# EUROPEAN PATENT APPLICATION

(11) **EP 4 253 450 A1**
(43) Date of publication of application: **04.10.2023**
(21) Application number: 21897915.1
(22) Date of filing: 22.11.2021
(51) Int. Cl.: C08J 3/12, C08L 101/00, C08L 101/12, C08J 5/18, C08G 63/60

(54) **LIQUID CRYSTAL POLYMER PARTICLES, THERMOSETTING RESIN COMPOSITION, AND MOLDED BODY**

(30) Priority: 24.11.2020 JP 2020194425
(71) Applicant: ENEOS Corporation, Chiyoda-ku Tokyo 100-8162 (JP)
(72) Inventor: EGASHIRA, Toshiaki, Tokyo 100-8162 (JP); MURAKAMI, Hiroaki, Tokyo 100-8162 (JP)
(74) Representative: Müller-Boré & Partner Patentanwälte PartG mbB
(86) International application number: PCT/JP2021/042826
(87) International publication number: WO 2022/113942

(57) **Abstract**

[Object] To provide a liquid crystal polymer particle which, when added to a resin film, can allow the resin film to be reduced in dielectric tangent with increases in surface roughness and linear coefficient of expansion of the resin film being suppressed.

[Solution] The liquid crystal polymer particle according to the present invention, in which 80% by mass or more of the entire particle is flat, and a longer size, a shorter size, and a thickness defined below of a flat liquid crystal polymer particle satisfy the following conditions (A) and (B): (A) an elongation as the ratio of the longer size and the shorter size is 1.2 or more and 5.0 or less, (B) a degree of flatness as the ratio of the shorter size and the thickness is 1.2 or more.

## Description

### BACKGROUND OF THE INVENTION

### Field of the Invention

The present invention relates to a liquid crystal polymer particle. Furthermore, the present invention relates to a thermosetting resin composition including the liquid crystal polymer particle, and a molded body using the thermosetting resin composition.

### Background Art

In recent years, according to increases in amounts of information and communications in the communication field, signals having frequencies in the high frequency band have been increasingly used in electronic devices, communication devices, and the like, and in particular, signals having frequencies in the gigahertz (GHz) band, frequencies of 10⁹ Hz or more, have been actively used. However, according to increases in frequencies of signals to be used, there is caused deterioration in qualities of output signals, which can lead to false recognition of information, namely, an increase in transmission loss. While the transmission loss is configured from the conductor loss due to conductors and the dielectric loss due to resin compositions for insulation, constituting electrical/electronic components such as electronic circuit boards in electronic devices or communication devices, the conductor loss is in proportion to the 0.5^{th} power of the frequency to be used and the dielectric loss is in proportion to the 1^{st} power of the frequency and thus the effect by the dielectric loss is very large in the high frequency band, in particular, the GHz band. In view of the circumstances, resins excellent in dielectric characteristics are studied as resins for use in circuit boards. For example, polyimide films are low in relative permittivity and thus are studied about use thereof, but there is room for improvement in terms of a reduction in dielectric tangent.

Since liquid crystal polymers are materials excellent in dielectric characteristics, liquid crystal polymer particles have been compounded as additives to resin films in order to improve dielectric characteristics. For example, Patent Literature 1 and 2 have disclosed substantially spherical liquid crystal polymer particles. Patent Literature 3 and 4 also have disclosed fibrillar liquid crystal polymer particles.

### Citation List

### Patent Literature

[Patent Literature 1] JP 6295013 B
[Patent Literature 2] JP 2019-001866 A
[Patent Literature 3] JP 2005-501760 A
[Patent Literature 4] JP 5904307 B

### SUMMARY OF THE INVENTION

### Technical Problem

However, the substantially spherical liquid crystal polymer particles described in Patent Literature 1 and 2, although are excellent in handleability of powders thereof, are difficult to control in terms of orientation in resin films when used as additives, and thus have the disadvantage of being increased in linear coefficient of expansion. The fibrillar liquid crystal polymer particles described in Patent Literature 3 and 4 cause easily particle entanglement and have trouble with dispersibility and handling, and are not practicable. Such properties make it difficult to pulverize such a fibrillar liquid crystal polymer particle so that a size D₅₀ corresponding to 50% of a cumulative distribution in a particle size distribution is 20 µm or less, and such a particle, when added to a resin film, may have an adverse effect on the surface roughness of the resin film. The resin film, if high in surface roughness, is increased in transmission loss due to deterioration in close contact ability between the resin film and a copper plate and roughness of a copper plate surface, when used in a copper clad laminate or the like.

Accordingly, an object of the present invention is to provide a liquid crystal polymer particle which, when added to a resin film, can allow the resin film to be reduced in dielectric tangent with increases in surface roughness and linear coefficient of expansion of the resin film being suppressed. Another object of the present invention is to provide a thermosetting resin composition including the liquid crystal polymer particle and a molded body obtained with the thermosetting resin composition.

### Solution to Problem

The present inventor has made intensive studies in order to solve the above problems, and as a result, has found that the shape of a liquid crystal polymer particle is controlled to be flat (substantially disc) to thereby allow a molded article, to which the liquid crystal polymer particle is added, to be excellent in dielectric characteristics with increases in surface roughness and linear coefficient of expansion being suppressed, as compared with a molded article to which a spherical liquid crystal polymer particle is added. The present invention has been completed based on such a finding.

In other words, one aspect of the present invention provides
a liquid crystal polymer particle in which 80% by mass or more of the entire particle is flat, wherein
a longer size, a shorter size, and a thickness defined below of a flat liquid crystal polymer particle satisfy the following conditions (A) and (B):
   (A) an elongation as the ratio of the longer size and the shorter size is 1.2 or more and 5.0 or less; and
   (B) a degree of flatness as the ratio of the shorter size and the thickness is 1.2 or more.

In an aspect of the present invention, preferably, the liquid crystal polymer particle has a melting point of 270°C or more, and
a size D₅₀ corresponding to 50% of a cumulative distribution in a particle size distribution is 20 µm or less and a size D₉₀ corresponding to 90% of the cumulative distribution is 2.5 times or less the D₅₀.

In an aspect of the present invention, the liquid crystal polymer particle preferably has a dielectric tangent of 0.001 or less.

In an aspect of the present invention, the liquid crystal polymer particle preferably contains a structural unit (I) derived from hydroxycarboxylic acid, a structural unit (II) derived from a diol compound, and a structural unit (III) derived from dicarboxylic acid.

In an aspect of the present invention, the structural unit (I) derived from hydroxycarboxylic acid is preferably a structural unit derived from 6-hydroxy-2-naphthoic acid.

In an aspect of the present invention, a compositional ratio of the structural unit (I) is preferably 40% by mol or more and 80% by mol or less relative to the entire structural unit of the liquid crystal polymer particle.

Another aspect of the present invention provides a thermosetting resin composition including the liquid crystal polymer particle and a thermosetting resin.

In another aspect of the present invention, a content of the liquid crystal polymer particle is preferably 5 parts by mass or more and 80 parts by mass or more based on 100 parts by mass of the thermosetting resin.

In another aspect of the present invention, the thermosetting resin is preferably at least one selected from the group consisting of an epoxy resin, a phenol resin, a polyimide resin, and a bismaleimide-triazine resin.

In another aspect of the present invention, a ratio of a viscosity of the thermosetting resin composition to a viscosity of the thermosetting resin is preferably 30 or less.

Another aspect of the present invention provides a molded body formed from the thermosetting resin composition, wherein
the molded body has a film shape, a sheet shape, or a plate shape, and
a ratio (a/b) of an average value a of a Feret's diameter in a longitudinal direction of the flat liquid crystal polymer particle and an average value b of a Feret's diameter in a perpendicular direction to the longitudinal direction is 1.2 or more.

In another aspect of the present invention, the ratio (a/b) is preferably 1.2 or more and 10.0 or less.

In another aspect of the present invention, the molded body is preferably a resin film having a thickness of 25 µm or less.

In another aspect of the present invention, the molded body is preferably the resin film having a surface roughness Ra of 1.0 µm or less.

### Advantageous Effects of Invention

The flat (substantially disc) liquid crystal polymer particle of the present invention is added to a molded article to thereby impart excellent dielectric characteristics with surface roughness being suppressed. In particular, a molded article having a film shape, to which the flat liquid crystal polymer particle is added, leads to easy orientation of a longitudinal axis of the flat liquid crystal polymer particle toward a lateral axis (MD direction) into the molded article, and thus an increase in linear coefficient of expansion can also be kept low.

### BRIEF DESCRIPTION OF THE DRAWINGS

FIG. 1 is a photograph imaging an ultrathin section in a vertical cross-sectional direction of a film obtained with a liquid crystal polymer particle of Example 1, with an optical microscope.
FIG. 2 is a schematic view illustrating a longer size, a shorter size, and a thickness of a flat liquid crystal polymer particle.
FIG. 3 is a schematic view illustrating a Feret's diameter in a longitudinal direction of a flat liquid crystal polymer particle in a molded body and a Feret's diameter in a perpendicular direction to the longitudinal direction.

### DETAILED DESCRIPTION OF THE INVENTION

### [Liquid crystal polymer particle]

In the liquid crystal polymer particle of the present invention, 80% by mass or more, preferably 85% by mass or more, more preferably 90% by mass or more, still more preferably 95% by mass or more of the entire particle is flat. In the present invention, a longer size, a shorter size, and a thickness defined below of a flat liquid crystal polymer particle satisfy the following conditions (A) and (B):
(A) an elongation as the ratio of the longer size and the shorter size is 1.2 or more and 5.0 or less,
(B) a degree of flatness as the ratio of the shorter size and the thickness is 1.2 or more. Such a liquid crystal polymer particle is added to a molded article, to thereby impart excellent dielectric characteristics with surface roughness being suppressed. In particular, a molded article having a film shape, to which the flat liquid crystal polymer particle is added, leads to easy orientation of a longitudinal axis of the flat liquid crystal polymer particle toward a lateral axis (MD direction) into the molded article, and thus an increase in linear coefficient of expansion can also be kept low.

The lower limit value of (A) the elongation as the ratio of the longer size and the shorter size of the flat liquid crystal polymer particle is preferably 1.5 or more, more preferably 1.7 or more. The upper limit value of the elongation is preferably 4.0 or less, more preferably 3.0 or less, further preferably 2.8 or less, still more preferably 2.5 or less. The lower limit value of (B) the degree of flatness as the ratio of the shorter size and the thickness of the flat liquid crystal polymer particle is preferably 1.5 or more, more preferably 1.7 or more. The upper limit value of the degree of flatness is not particularly limited and, for example, may be 10.0 or less, may be 5.0 or less, or may be 3.0 or less.

### <Method for measuring longer size, shorter size, and thickness of liquid crystal polymer particle>

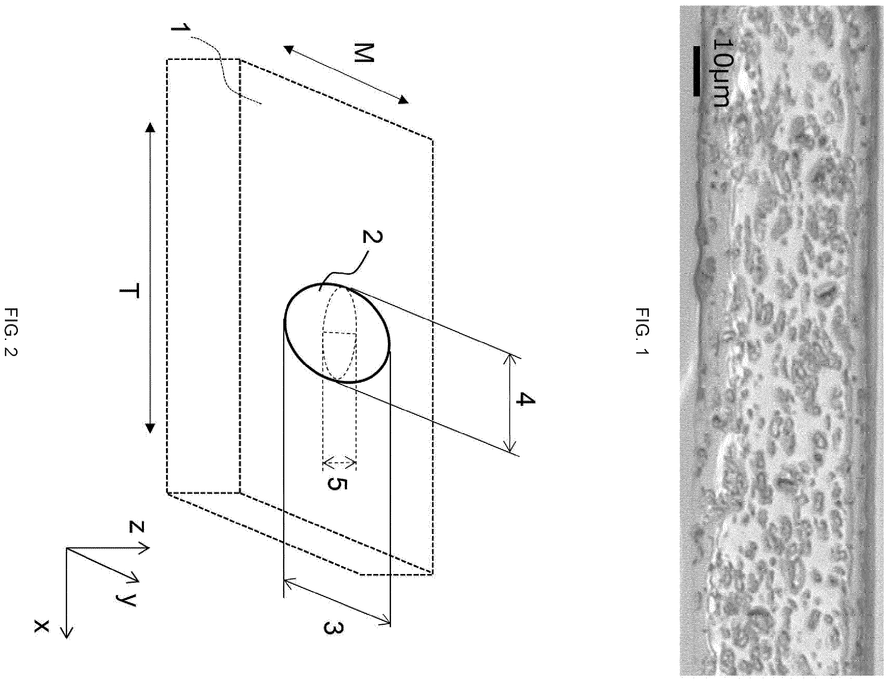

A film having a thickness of about 25 µm is produced by adding the liquid crystal polymer particle to a resin, for measurement of the longer size, the shorter size, and the thickness of the liquid crystal polymer particle. The film obtained is cut in a cross-sectional direction by use of a cryo microtome, and thus an ultrathin section having a thickness of 0.5 to 2.5 µm is produced. A cross section of the ultrathin section can be observed with an optical microscope (optical microscope (Model number: VHX6000 manufactured by KEYENCE CORPORATION)), and an image of the cross section can be analyzed for calculation. Since an object is to measure the shape of the liquid crystal polymer particle, common film formation conditions may be adopted in production of the film and no conditions for significantly changing the shape of the liquid crystal polymer particle are selected. In a case where the longer size and the shorter size are measured, a transverse cross-section (x-y plane in FIG. 2) at a position corresponding to one-half of the film thickness is observed. In a case where the shorter size and the thickness are measured, a vertical cross-section (x-z plane in FIG. 2) along with a TD direction of the film is observed. An area of 400 µm × 300 µm is defined as one field of view, and three fields of view of each of the transverse cross-section and the vertical cross-section are observed at a magnification of 1000x. All the three fields of view of the transverse cross-section are set so as to include the center in the TD direction of the film and not so as to be overlapped with one another. As one example, a position corresponding to one-fourth, a position corresponding to two-fourths, and a position corresponding to three-fourths in the MD direction of the film can be adopted. All the three fields of view of the vertical cross-section are set so as to include the center in the thickness direction and not so as to be overlapped with one another. As one example, a position corresponding to one-fourth, a position corresponding to two-fourths, and a position corresponding to three-fourths in the TD direction of the film can be adopted. The longer size, the shorter size, and the Feret's diameter of the thickness of the liquid crystal polymer particle are each measured at at least 100 positions or more in each of the fields of view. The longer size, the shorter size, and the thickness of the liquid crystal polymer particle can be modulated depending on, for example, the synthetic method and the pulverizing method of the liquid crystal polymer particle, and sieve conditions after pulverizing.

In the present invention, the particle size distribution of the liquid crystal polymer particle can be measured with a laser diffraction/scattering method particle size distribution measurement apparatus (manufactured by BECKMAN COULTER, LS 13 320 dry system, equipped with tornado dry powder module). The size D₅₀ corresponding to 50% of the cumulative distribution in the particle size distribution (hereinafter, referred to as "D₅₀") represents a particle size value where the cumulative distribution reaches 50% from the smaller particle size side, and the size D₉₀ corresponding to 90% of the cumulative distribution (hereinafter, referred to as "D₉₀") represents a particle size value where the cumulative distribution reaches 90% from the smaller particle size side.

In the liquid crystal polymer particle of the present invention, preferably, the D₅₀ in the particle size distribution is 20 µm or less and the D₉₀ is 2.5 times or less the D₅₀.

The D₅₀ is preferably 0.1 µm or more, more preferably 1 µm or more, further preferably 3 µm or more, more preferably 5 µm or more. The D₅₀ is preferably 15 µm or less, more preferably 12 µm or less, further preferably 10 µm or less, still more preferably 6 µm or less.

The D₉₀ is preferably 2.2 times or less, more preferably 2.0 times or less, further preferably 1.8 times or less the D₅₀.

The D₅₀ and D₉₀ values as parameters in the particle size distribution of the liquid crystal polymer particle can be modulated in the range, to thereby allow for a reduction in dielectric tangent with increases in surface roughness and linear coefficient of expansion of a resin film being suppressed, in the case of addition to the resin film. The D₅₀ and D₉₀ values can be modulated depending on, for example, the synthetic method, the pulverizing method (pulverization pressure, feeding conditions, and the like), and classification conditions (sieve size after pulverization, air flow classification conditions, and the like) of the liquid crystal polymer particle.

The liquid crystallinity of the liquid crystal polymer can be confirmed with a polarization microscope (trade name: BH-2) manufactured by OLYMPUS CORPORATION, equipped with a hot stage for microscopes (trade name: FP82HT) manufactured by METTLER TOLEDO, by heating and melting the liquid crystal polymer on a microscope heating stage and then observing the presence of optical anisotropy.

The melting point of the liquid crystal polymer particle is usually, 270°C or more, the lower limit value thereof is preferably 280°C or more, more preferably 290°C or more, further preferably 300°C or more and the upper limit value thereof is preferably 370°C or less, preferably 360°C or less, further preferably 350°C or less. The melting point of the liquid crystal polymer can be in the numerical range to thereby allow a resin film obtained by addition of the liquid crystal polymer particle of the present invention to be enhanced in heat resistance. The melting point of the liquid crystal polymer can be herein measured with, for example, a differential scanning calorimeter (DSC) manufactured by Hitachi High-Tech Science Corporation.

The dielectric tangent (measurement frequency: 10 GHz) of the liquid crystal polymer particle is 0.001 or less, preferably 0.0009 or less, more preferably 0.0008 or less, further preferably 0.0007 or less. The value is a measurement value of the dielectric tangent in the in-plane direction of an injection molded article of the liquid crystal polymer particle. The injection molded article is a flat plate-shaped test piece of 30 mm × 30 mm × 0.4 mm (thickness).

The liquid crystal polymer as a raw material of the liquid crystal polymer particle according to the present invention is not particularly limited in terms of composition thereof, and preferably contains a structural unit (I) derived from aromatic hydroxycarboxylic acid, a structural unit (II) derived from an aromatic diol compound, and a structural unit (III) derived from aromatic dicarboxylic acid. Furthermore, the liquid crystal polymer in the present invention may further contain a structural unit (IV) as any structural unit other than the structural units (I) to (III). Hereinafter, each structural unit contained in the liquid crystal polymer is described.

### (Structural unit (I) derived from hydroxycarboxylic acid)

The unit (I) constituting the liquid crystal polymer is a structural unit derived from hydroxycarboxylic acid, and is preferably a structural unit derived from aromatic hydroxycarboxylic acid, represented by the following formula (I). Only one kind of the structural unit (I), or two or more kinds thereof may be contained. 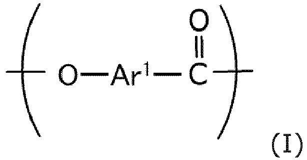 In the formula, Ar¹ is selected from the group consisting of a phenyl group, a biphenyl group, 4,4'-isopropylidenediphenyl group, a naphthyl group, an anthryl group and a phenanthryl group each optionally having a substituent. In particular, a naphthyl group is preferable. Examples of the substituent include hydrogen, an alkyl group, an alkoxy group, and fluorine. The number of carbon atoms in the alkyl group is preferably 1 to 10, more preferably 1 to 5. A linear alkyl group or a branched alkyl group may be adopted. The number of carbon atoms in the alkoxy group is preferably 1 to 10, more preferably 1 to 5.

Examples of a monomer imparting the structural unit represented by the formula (I) include 6-hydroxy-2-naphthoic acid (HNA, the following formula (1)), and acylated products, ester derivatives, and acid halides thereof.

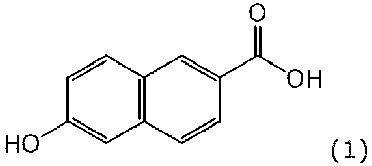

The lower limit value of the compositional ratio (% by mol) of the structural units (I) to the total structural unit of the liquid crystal polymer is preferably 40% by mol or more, more preferably 45% by mol or more, further preferably 50% by mol or more, still more preferably 55% by mol or more. The upper limit value thereof is preferably 80% by mol or less, more preferably 75% by mol or less, further preferably 70% by mol or less, still more preferably 65% by mol or less. When the structural unit (I) is contained in combination of two or more kinds thereof, the total molar ratio may fall within the compositional ratio range.

### (Structural unit (II) derived from a diol compound)

The unit (II) constituting the liquid crystal polymer is a structural unit derived from a diol compound, and is preferably a structural unit derived from an aromatic diol compound, represented by the following formula (II). Only one kind of the structural unit (II), or two or more kinds thereof may be contained. 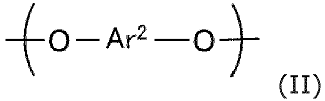 In the formula, Ar² is selected from the group consisting of a phenyl group, a biphenyl group, 4,4'-isopropylidenediphenyl group, a naphthyl group, an anthryl group and a phenanthryl group each optionally having a substituent. In particular, a phenyl group and a biphenyl group are preferable. Examples of the substituent include hydrogen, an alkyl group, an alkoxy group, and fluorine. The number of carbon atoms in the alkyl group is preferably 1 to 10, more preferably 1 to 5. A linear alkyl group or a branched alkyl group may be adopted. The number of carbon atoms in the alkoxy group is preferably 1 to 10, more preferably 1 to 5.

Examples of a monomer imparting the structural unit (II) include 4,4-dihydroxybiphenyl (BP, the following formula (2)), hydroquinone (HQ, the following formula (3)), methylhydroquinone (MeHQ, the following formula (4)), 4,4'-isopropylidenediphenol (BisPA, the following formula (5)), and acylated products, ester derivatives, and acid halides thereof. In particular, 4,4-dihydroxybiphenyl (BP), and acylated products, ester derivatives and acid halides thereof are preferably used.

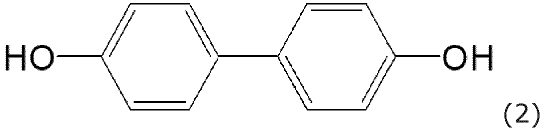

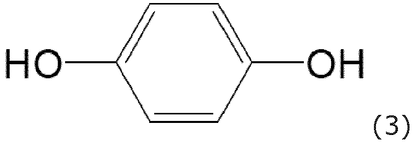

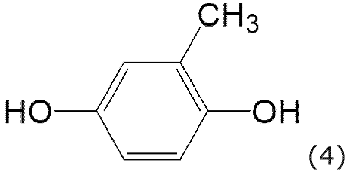

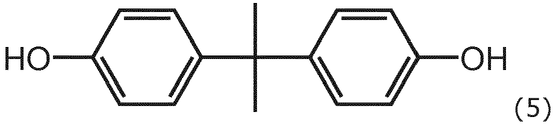

The lower limit value of the compositional ratio (% by mol) of the structural unit (II) to the total structural unit of the liquid crystal polymer is preferably 10% by mol or more, more preferably 12.5% by mol or more, further preferably 15% by mol or more, still more preferably 17.5% by mol or more. The upper limit value thereof is preferably 30% by mol or less, more preferably 27.5% by mol or less, further preferably 25% by mol or less, still more preferably 22.5% by mol or less. When the structural unit (II) is contained in combination of two or more kinds thereof, the total molar ratio may fall within the compositional ratio range.

### (Structural unit (III) derived from aromatic dicarboxylic acid)

The unit (III) constituting the liquid crystal polymer is a structural unit derived from dicarboxylic acid, and is preferably a structural unit derived from aromatic dicarboxylic acid, represented by the following formula (III). Only one kind of the structural unit (III), or two or more kinds thereof may be contained.

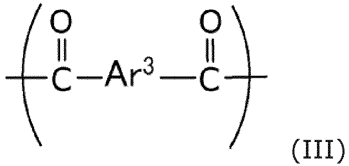

In the formula, Ar³ is selected from the group consisting of a phenyl group, a biphenyl group, 4,4'-isopropylidenediphenyl group, a naphthyl group, an anthryl group and a phenanthryl group each optionally having a substituent. In particular, a phenyl group and a naphthyl group are preferable. Examples of the substituent include hydrogen, an alkyl group, an alkoxy group, and fluorine. The number of carbon atoms in the alkyl group is preferably 1 to 10, more preferably 1 to 5. A linear alkyl group or a branched alkyl group may be adopted. The number of carbon atoms in the alkoxy group is preferably 1 to 10, more preferably 1 to 5.

Examples of a monomer imparting the structural unit (III) include terephthalic acid (TPA, the following formula (6)), isophthalic acid (IPA, the following formula (7)), 2,6-naphthalenedicarboxylic acid (NADA, the following formula (8)), and acylated products, ester derivatives, and acid halides thereof.

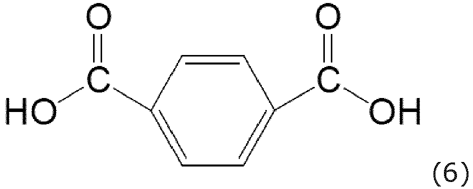

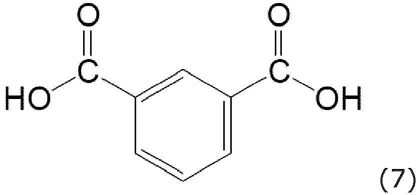

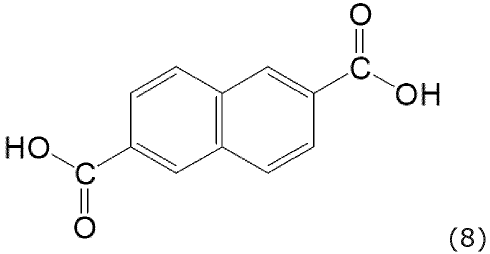

The lower limit value of the compositional ratio (% by mol) of the structural unit (III) to the total structural unit of the liquid crystal polymer is preferably 10% by mol or more, more preferably 12.5% by mol or more, further preferably 15% by mol or more, still more preferably 17.5% by mol or more. The upper limit value thereof is preferably 30% by mol or less, more preferably 27.5% by mol or less, further preferably 25% by mol or less, still more preferably 22.5% by mol or less. When the structural unit (II) is contained in combination of two or more kinds thereof, the total molar ratio may fall within the compositional ratio range. The compositional ratio of the structural unit (II) and the compositional ratio of the structural unit (III) are substantially equivalent to each other ((structural unit (II) ~ structural unit (III)).

### (Structural unit (IV) derived from other monomer)

The liquid crystal polymer may further contain any structural unit other than the structural units (I) to (III). A structural unit (IV) is not particularly limited as long as it is derived from a monomer other than the monomers respectively imparting the structural units (I) to (III) and is derived from a polymerizable monomer which is polymerizable with the monomers respectively imparting the structural units (I) to (III). Examples of a polymerizable group include a hydroxy group, a carboxyl group, an amine group, and an amide group. A monomer imparting the structural unit (IV) has one or more, preferably two or more of such polymerizable groups. In a case where two or more of such polymerizable groups are contained, these polymerizable groups may be the same as or different from each other. Only one kind of the structural unit (IV), or two or more kinds thereof may be contained.

Examples of the structural unit (IV) include the following structural unit (IV-1).

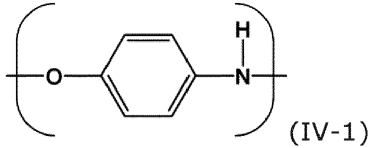

Examples of a monomer imparting the structural unit (IV-1) include acetoaminophenone (AAP, the following formula (9)), p-aminophenol, 4'-acetoxyacetanilide, and acylated products, ester derivatives, and acid halides thereof.

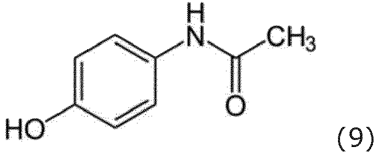

Examples of the structural unit (IV) include the following structural unit (IV-2).

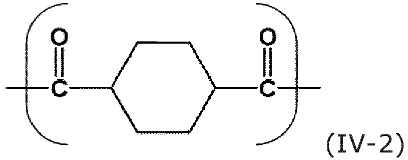

Examples of a monomer imparting the structural unit (IV-2) include 1,4-cyclohexanedicarboxylic acid (CHDA, the following formula (10)) and acylated products, ester derivatives, and acid halides thereof.

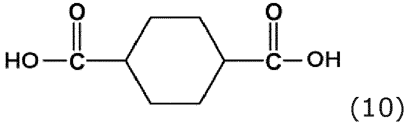

The compositional ratio (% by mol) of the structural unit (IV) relative to the entire structural unit of the liquid crystal polymer can be appropriately set depending on the compositional ratio of the structural units (I) to (III). Specifically, the compositional ratio of the respective structural units may be appropriately set so that the monomer ratio (molar ratio) between a carboxyl group in monomer loading and a hydroxy group and/or an amine group falls within about 1:1.

Examples of preferable compounding of the liquid crystal polymer include the following.
45% by mol ≤ structural unit (I) derived from 6-hydroxy-2-naphthoic acid ≤ 75% by mol
12% by mol ≤ structural unit (II) derived from aromatic diol compound ≤ 27.5% by mol
3% by mol ≤ structural unit structural unit (IIIA) derived from terephthalic acid ≤ 25% by mol
2% by mol ≤ structural unit (IIIB) derived from 2,6-naphthalenedicarboxylic acid ≤ 9% by mol.

Examples of more preferable compounding of the liquid crystal polymer include the following.
50% by mol ≤ structural unit (I) derived from 6-hydroxy-2-naphthoic acid ≤ 70% by mol
15% by mol ≤ structural unit (II) derived from aromatic diol compound ≤ 25% by mol
9% by mol ≤ structural unit structural unit (IIIA) derived from terephthalic acid ≤ 22% by mol
3% by mol ≤ structural unit (IIIB) derived from 2,6-naphthalenedicarboxylic acid ≤ 6% by mol.

Examples of still more preferable compounding of the liquid crystal polymer include the following.
54% by mol ≤ structural unit (I) derived from 6-hydroxy-2-naphthoic acid ≤ 66% by mol
17% by mol ≤ structural unit (II) derived from aromatic diol compound ≤ 23% by mol
11% by mol ≤ structural unit structural unit (IIIA) derived from terephthalic acid ≤ 20% by mol
3% by mol ≤ structural unit (IIIB) derived from 2,6-naphthalenedicarboxylic acid ≤ 6% by mol.

When each structural unit is contained in the range relative to the total structural unit of the liquid crystal polymer, a liquid crystal polymer particle low in dielectric tangent can be obtained.

### (Method for producing liquid crystal polymer)

The liquid crystal polymer can be produced by polymerizing monomers optionally imparting structural units (I) to (III) and a monomer optionally imparting optionally a structural unit (IV), according to a conventionally known method. In one embodiment, the liquid crystal polymer in the present invention can also be produced by two-stage polymerization where a prepolymer is produced by melt polymerization and further is subjected to solid phase polymerization.

The melt polymerization can be performed under acetic acid reflux in the presence of acetic anhydride. The melt polymerization is preferably performed by allowing 1.05 to 1.15 molar equivalents of acetic anhydride to be present based on the total hydroxyl group in the monomers constituting the liquid crystal polymer, from the viewpoint of efficiently providing the liquid crystal polymer.

In the case of a polymerization reaction at two stages of the melt polymerization and subsequent solid phase polymerization, a method is preferably selected which is, for example, a method involving cooling and solidifying and then pulverizing the prepolymer obtained by the melt polymerization, to thereby provide a powdery or flaky prepolymer, and thereafter performing a known solid phase polymerization method. For example, preferred is a method of heat-treating such a prepolymer resin at a temperature ranging from 200 to 350°C under an atmosphere of an inert gas such as nitrogen or under vacuum for 1 to 30 hours. The solid phase polymerization may be performed with stirring or under still standing with no stirring.

A catalyst may or may not be used in the polymerization reaction. The catalyst used can be any conventionally known catalyst for liquid crystal polymer formation. Examples of the catalyst include metal salt catalysts such as magnesium acetate, stannous acetate, tetrabutyl titanate, lead acetate, sodium acetate, potassium acetate and antimony trioxide, and organic compound catalysts such as a nitrogen-containing heterocyclic compound such as N-methylimidazole. The amount of the catalyst used is not particularly limited, and is preferably 0.0001 to 0.1 parts by weight based on 100 parts by weight of the total monomer.

The polymerization reaction apparatus in the melt polymerization is not particularly limited, and a reaction apparatus for use in a general reaction of a high-viscosity fluid is preferably used. Examples of such a reaction apparatus include mixing apparatuses commonly used in resin kneading, for example, a stirring tank-type polymerization reaction apparatus having a stirring apparatus provided with a stirring blade having any shape such as an anchor, multiple-stage, spiral band or spiral shaft shape, or a modified shape thereof, or a kneader, a roll mill or a banbury mixer.

### [Method for producing liquid crystal polymer particle]

The liquid crystal polymer particle of the present invention can be produced by pulverizing/classifying the liquid crystal polymer with a conventionally known pulverization/classification apparatus. The liquid crystal polymer particle is known to tend to exhibit shape anisotropy such as fibrillation if the temperature in pulverization is higher, and thus the balance between the frequency of particle collision and the removal rate of heat generated by the collision can be changed, for example, by modulating the pulverization pressure in the pulverization apparatus and air flow in the classification apparatus and thus the elongation, the degree of flatness, and the particle size of the particle can be modulated.

### [Thermosetting resin composition]

The thermosetting resin composition of the present invention includes the liquid crystal polymer particle of the present invention, and a thermosetting resin. Examples of the thermosetting resin include an epoxy resin, a phenol resin, a polyimide resin, a cyanate resin, an acrylic resin, a maleimide resin and a bismaleimide-triazine resin, and in particular a polyimide resin is preferable. Only one kind of these thermosetting resins, or two or more kinds thereof may be contained.

The content of the liquid crystal polymer particle in the thermosetting resin composition is preferably 5 parts by mass or more and 80 parts by mass or more, more preferably 10 parts by mass or more and 70 parts by mass or more, further preferably 15 parts by mass or more and 60 parts by mass or more, still more preferably 20 parts by mass or more and 50 parts by mass or more based on 100 parts by mass of the thermosetting resin. If the content of the liquid crystal polymer particle falls within the range, a resin film produced can be reduced in dielectric tangent with increases in surface roughness and linear coefficient of expansion of the resin film being suppressed.

While the thermosetting resin composition of the present embodiment contains the liquid crystal polymer particle and thus is reduced in dielectric tangent, but the thermosetting resin composition is increased in viscosity by addition of the liquid crystal polymer particle. The liquid crystal polymer particle of the present embodiment is used to thereby enable a remarkable increase in viscosity of the thermosetting resin composition to be suppressed, and thus is preferable in terms of production. The ratio of the viscosity of the thermosetting resin composition including the liquid crystal polymer particle of the present embodiment, relative to the viscosity of the thermosetting resin, is preferably 30 or less. The upper limit of the ratio of the viscosity of the thermosetting resin composition is more preferably 20, 10, 5, 3, or 2.

### (Method for producing thermosetting resin composition)

The method for producing the thermosetting resin composition of the present invention preferably includes a step of mixing the liquid crystal polymer particle and the thermosetting resin at a temperature less than the melting point of the liquid crystal polymer particle. Such mixing can be made at a temperature less than the melting point of the liquid crystal polymer particle to thereby provide the thermosetting resin composition without any change in particle size distribution of the liquid crystal polymer particle as much as possible. The mixing method can be performed by a conventionally known method. For example, the mixing can be made by use of a banbury mixer, a kneader, a one- or two-axis extruder, or the like.

### (Molded body)

The molded body of the present invention can be obtained by use of the thermosetting resin composition. The molded article according to the present invention may include any component other than the liquid crystal polymer particle and the thermosetting resin as long as the effects of the present invention are not impaired. Examples of such other component include a colorant, a dispersant, a plasticizer, an antioxidant, a curing agent, a flame retardant, a heat stabilizer, an ultraviolet absorber, an antistatic agent, and a surfactant.

The molded body preferably has a film shape, a sheet shape, or a plate shape. The thickness of the molded body is not particularly limited, and is usually 10 µm or more and 200 µm or less, preferably 150 µm or less, more preferably 100 µm or less, further preferably 80 µm or less. The molded body using the thermosetting resin composition including the liquid crystal polymer particle of the present invention can be suppressed in surface roughness even if it is a thin film having a thickness of 200 µm or less.

The ratio (a/b) of the average value a of the Feret's diameter in the longitudinal direction (MD direction) of the liquid crystal polymer particle in the molded body to the average value b of the Feret's diameter in the perpendicular direction (TD direction) thereto is preferably 1.2 or more, more preferably 1.5 or more, further preferably 1.7 or more. The upper limit value of the ratio (a/b) is not particularly limited, and, for example, may be 5 or less or may be 3 or less. If the ratio (a/b) is 1.2 or more, the liquid crystal polymer particle is sufficiently oriented in a longitudinal direction in the molded body, and the dielectric tangent can be effectively reduced.

### <Method for measuring ratio (a/b)>

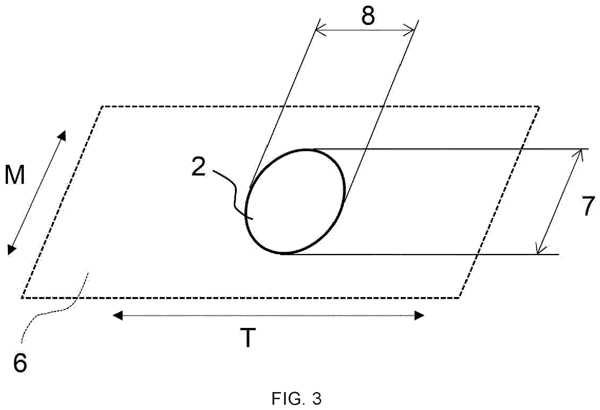

The ratio (a/b) can be measured according to the observation method of the liquid crystal polymer particle in a transverse cross-section in <Method for measuring longer size, shorter size, and thickness of liquid crystal polymer particle> described above. Specifically, a transverse cross-section (FIG. 3) of a molded body to which the liquid crystal polymer particle is added can be observed with an optical microscope (Model number: VHX6000 manufactured by KEYENCE CORPORATION)) and an image obtained can be analyzed for calculation. An area of 400 µm × 300 µm is defined as one field of view, and three fields of view of the transverse cross-section are observed at a magnification of 1000x. All the three fields of view of the transverse cross-section are set so as to include the center in the TD direction of the film and not so as to be overlapped with one another. As one example, a position corresponding to one-fourth, a position corresponding to two-fourths, and a position corresponding to three-fourths in the MD direction of the film can be adopted. The Feret's diameter of the liquid crystal polymer particle is measured at at least 100 or more positions in each of the fields of view, and is calculated as the average value ratio.

### (Resin film)

The resin film of the present invention can be reduced in dielectric tangent with increases in surface roughness and linear coefficient of expansion of the resin film being suppressed, by use of the liquid crystal polymer particle. The surface roughness Ra of the resin film is preferably 1.0 µm or less, more preferably 0.9 µm or less, further preferably 0.8 µm or less.

The thickness of the resin film is preferably 25 µm or less, more preferably 20 µm or less, and may be 10 µm or more. Even if such a thin film is produced, the surface roughness Ra can be suppressed by use of the liquid crystal polymer particle.

### (Method for producing molded body)

In the present invention, the molded body can be obtained by molding the thermosetting resin composition by a conventionally known method. Examples of the molding method include press molding, foam molding, injection molding, extrusion molding, and punch molding. The molded body produced as described above can be processed into any shape depending on the intended use. The shape of the molded body is not limited, and is, for example, a film shape, a sheet shape, or a plate shape. In particular, the molded body, in which the liquid crystal polymer particle of the present invention is used, thus can be low in surface roughness even if it is a thin film, and thus is suitable for a molded body having a film shape.

### (Electronic circuit board)

The electronic circuit board of the present invention can be obtained with the thermosetting resin composition. The electronic circuit board of the present invention includes the molded body. The electronic circuit board is preferably a flexible circuit board because of, when formed into a thin film, being capable of being reduced in dielectric tangent with surface roughness being suppressed.

### (Other form)

The liquid crystal polymer particle of the present invention not only is used in the film or the electronic circuit board, as the molded article, but also can be used in, for example, a bonding sheet, a prepreg, or a coverlay. The liquid crystal polymer particle can also be used in, for example, a paste composition without any limitation to the molded article, and in this case, can also be used in, for example, an adhesive, an interlayer insulation material, or a sealing material.

### EXAMPLES

Hereinafter, the present invention is more specifically described with reference to Examples, but the present invention is not limited to these Examples.

### <Synthesis of liquid crystal polymer>

### (Synthesis Example 1)

Sixty percent by mol of 6-hydroxy-2-naphthoic acid (HNA), 20% by mol of 4,4-dihydroxybiphenyl (BP), 15.5% by mol of terephthalic acid (TPA), and 4.5% by mol of 2,6-naphthalenedicarboxylic acid (NADA) were added to a polymerization vessel having a stirring blade, potassium acetate and magnesium acetate as catalysts were loaded thereinto, depressurization of the polymerization vessel and nitrogen injection thereinto were performed three times for purging with nitrogen, thereafter acetic anhydride (1.08 molar equivalents relative to a hydroxyl group) was further added, and the resultant was heated to 150°C and subjected to an acetylation reaction in a reflux state for 2 hours.

After completion of the acetylation, the polymerization vessel in the state where acetic acid was distilled out was heated at 0.5°C/min, a polymerized product was extracted after the temperature of a melt in this tank reached 310°C, and the polymerized product was cooled and solidified. The polymerized product obtained was pulverized to a size so as to pass through a sieve having an aperture of 2.0 mm, and thus a prepolymer was obtained.

Next, the prepolymer obtained was heated from room temperature to 295°C over 14 hours in an oven manufactured by Yamato Scientific co., ltd., thereafter the temperature was retained at 295°C for 1 hour, to thereby perform solid phase polymerization. Thereafter, heat was released naturally at room temperature, and thus a liquid crystal polymer A was obtained. The liquid crystal polymer A was heated and molten on a microscope heating stage and was then confirmed based on the presence of optical anisotropy to exhibit liquid crystallinity, by use of a polarization microscope (trade name: BH-2) manufactured by OLYMPUS CORPORATION, equipped with a hot stage for microscopes (trade name: FP82HT) manufactured by METTLER TOLEDO.

### <Production of liquid crystal polymer particle>

### (Example 1)

A powder of the liquid crystal polymer A was pulverized with a collision plate type sonic air flow pulverizer (built-in classification machine (adjust ring: 60 mm, center navel: Φ60 mm, blower setting: -45 kPa), manufactured by Nippon Pneumatic Mfg. Co., Ltd., model number: SPK-12+UFS10) in conditions of a pulverization pressure of 0.70 MPa and 10 kg/h. As a result, a flat liquid crystal polymer A1 was obtained.

### (Example 2)

The flat liquid crystal polymer A1 obtained in Example 1 was further classified with a classification machine (adjust ring height 30 mm, distance ring height 15 mm, guide vane clearance 4 mm, center navel diameter Φ40 mm, louver opening 1 mm, manufactured by Nippon Pneumatic Mfg. Co., Ltd., model number: DXF2), and thus a flat liquid crystal polymer particle A2 was obtained.

### (Example 3)

A flat liquid crystal polymer A3 was obtained by pulverization in the same manner as in Example 1 except that the pulverization pressure was 0.75 MPa.

### (Comparative Example 1)

A powder of the liquid crystal polymer A was micronized by a method described in Example 1 of JP 6697644 B, and thus a truly spherical liquid crystal polymer A4 was obtained.

### <Evaluation of liquid crystal polymer>

### (Measurement of elongation and degree of flatness of particle)

A polyamic acid varnish was prepared in a glass vessel equipped with a stirring apparatus, each of the liquid crystal polymer particles obtained was dispersed in a dispersion medium and the resultant was added and stirred, and thus a suspension was obtained. Herein, the concentration of each of the liquid crystal polymer particles was adjusted so as to be 10 to 20 parts by mass based on 100 parts by mass of polyamic acid. A glass substrate was coated with the suspension obtained, and the resultant was dried and subjected to curing at 300°C, and thus a film having a thickness of about 25 µm was produced. The film obtained was cut in a cross-sectional direction by use of a cryo microtome, and thus an ultrathin section having a thickness of 0.5 to 2.5 µm was produced. The thickness was set depending on the number average size of the particle for observation so that 100 or more of such particles could be observed without being overlapped with one another in each field of view of a microscope, at a magnification described below. A thickness of 0.5 µm was suitable for a particle having a volume average size of about 5 µm. A cross section of the ultrathin section obtained was observed with an optical microscope (Model number: VHX6000 manufactured by KEYENCE CORPORATION) according to <Method for measuring longer size, shorter size, and thickness of liquid crystal polymer particle> described above, and the ratio of shorter size/thickness was defined as the degree of flatness of the particle. FIG. 1 is a photograph imaging an ultrathin section in a cross-sectional direction of a film obtained with a liquid crystal polymer particle of Example 1, with an optical microscope.

Next, the film was cut in a horizontal direction, with a cryo microtome, and an ultrathin section having a thickness of 0.5 to 2.5 µm was produced. The ultrathin section obtained was observed with an optical microscope, and the ratio of longer size/shorter size was defined as the elongation of the particle.

### (Measurement of particle size distribution)

The particle size distribution of each of the liquid crystal polymer particles obtained was measured with a laser diffraction/scattering method particle size distribution measurement apparatus (manufactured by BECKMAN COULTER, LS 13 320 dry system, equipped with tornado dry powder module). The D₅₀ and D₉₀, as parameters representing the particle size distribution, were obtained as the computing results from the measurement data. The results were shown in Table 1.

### (Measurement of melting point)

The melting point of each of the liquid crystal polymers obtained was measured with a differential scanning calorimeter (DSC) manufactured by Hitachi High-Tech Science Corporation. Herein, an endothermic peak top obtained in complete melting of such each polymer by temperature rise from room temperature to 360 to 380°C at a rate of temperature rise of 10°C/min, then temperature dropping to 30°C at a rate of 10°C/min and furthermore temperature rise to 380°C at 10°C/min was defined as the melting point (Tm₂). The measurement results were shown in Table 1.

### (Measurement of dielectric tangent (10 GHz))

Each of the liquid crystal polymers obtained was used, and heated and molten under a condition of from each melting point to the melting point + 30°C, and injection molded by use of a mold of 30 mm × 30 mm × 0.4 mm (thickness), to thereby produce each flat plate-shaped test piece. Subsequently, the flat plate-shaped test piece was used for measurement of the dielectric tangent at a frequency of 10 GHz with a Network analyzer N5247A from Keysight Technologies, according to a split post dielectric resonator method (SPDR method). A sample of each type was measured at N = 4, and the average value of four times was shown in Table 1.

**[Table 1]**

| | Liquid crystal polymer particle | Conditions | | Particle size distribution | | Melting point (°C) | Dielectric tangent tanδ |
|---|---|---|---|---|---|---|---|
| | | (A) Elongation | (B) Degree of flatness | D₅₀ (µm) | D₉₀/D₅₀ (µm) | | |
| Example 1 | A1 | 1.8 | 1.8 | 5.3 | 1.7 | 319 | 0.0007 |
| Example 2 | A2 | 2.0 | 2.1 | 4.6 | 1.7 | 319 | 0.0007 |
| Example 3 | A3 | 1.8 | 2.3 | 5.9 | 1.8 | 319 | 0.0007 |
| Comparative Example 1 | A4 | 1.1 | 1.1 | 10.9 | 1.5 | 319 | 0.0007 |

### <Production of film>

### (Example 4)

A glass vessel equipped with a stirring apparatus was loaded with 60% of m-toluidine (tol), 40% of 4,4'-diaminodiphenyl ether (DDE) and N,N-dimethylacetamide at a predetermined concentration, these were stirred under a nitrogen atmosphere at 25°C, and thus a solution was obtained. The solution was charged with 100% of pyromellitic dianhydride (PMDA) in several portions, the resultant was stirred under a nitrogen atmosphere at 25°C, and thus a polyamic acid varnish was obtained. A suspension was obtained by adding to the polyamic acid varnish obtained, 30 parts by mass of the liquid crystal polymer particle A1 based on 100 parts by mass of polyamic acid in the varnish. A glass substrate was coated with the suspension obtained, the resultant was dried and subjected to curing at 300°C, and thus a film having a thickness of 25 µm was produced.

### (Example 5)

A film having a thickness of 25 µm was produced in the same manner as in Example 4 except that the amount of the liquid crystal polymer particle A1 added was changed to 50 parts by mass based on 100 parts by mass of polyamic acid.

### (Example 6)

A film having a thickness of 25 µm was produced in the same manner as in Example 4 except that 30 parts by mass of the liquid crystal polymer particle A2 based on 100 parts by mass of polyamic acid was added instead of the liquid crystal polymer particle A1.

### (Example 7)

A film having a thickness of 25 µm was produced in the same manner as in Example 4 except that 50 parts by mass of the liquid crystal polymer particle A2 based on 100 parts by mass of polyamic acid was added instead of the liquid crystal polymer particle A1.

### (Example 8)

A film having a thickness of 25 µm was produced in the same manner as in Example 4 except that 30 parts by mass of the liquid crystal polymer particle A3 based on 100 parts by mass of polyamic acid was added instead of the liquid crystal polymer particle A1.

### (Example 9)

A film having a thickness of 25 µm was produced in the same manner as in Example 4 except that 50 parts by mass of the liquid crystal polymer particle A3 based on 100 parts by mass of polyamic acid was added instead of the liquid crystal polymer particle A1.

### (Comparative Example 2)

A film having a thickness of 25 µm was produced in the same manner as in Example 3 except that 50 parts by mass of the liquid crystal polymer particle A4 based on 100 parts by mass of polyamic acid was added instead of the liquid crystal polymer particle A1.

### (Reference Example)

A film having a thickness of 25 µm was produced in the same manner as in Example 4 except that no liquid crystal polymer particle A1 was added.

### <Performance evaluation>

### (Measurement of orientation)

Each of the films produced was cut in a cross-sectional direction by use of a cryo microtome, and thus an ultrathin section having a thickness of 0.5 µm was produced. The ultrathin section obtained was subjected to cross section observation and measurement of the Feret's diameters in the longitudinal direction of each of the polymer particles and in the perpendicular direction thereto, with an optical microscope (Model number: VHX6000 manufactured by KEYENCE CORPORATION) according to <Method for measuring ratio (a/b)> described above. The ratio (a/b) of the average value a of the Feret's diameter in the longitudinal direction to the average value b of the Feret's diameter in the perpendicular direction was calculated, and the results were shown in Table 2.

### (Measurement of linear coefficient of expansion)

Each of the films produced was cut to a width of about 4 mm, and a strip-shaped measurement sample was obtained. The measurement sample was subjected to measurement of the linear coefficient of expansion (CTE) of the sample in a tensile mode with a thermal mechanical analyzer (manufactured by Hitachi High-Tech Science Corporation, model number: TMA7000). The measurement was made at an inter-measurement distance of 15 mm for two cycles where temperature rise and temperature drop were made at a rate of 10°C/min in a temperature region of from 30°C to 230°C. The CTE was measured in a temperature region of from 170°C to 230°C, equal to or more than the glass transition point, in temperature rise at the 2nd cycle. The measurement results were shown in Table 2.

### (Measurement of surface roughness)

Each of the films produced was cut out to a strip shape of 3 mm × 80 mm, and thus a film sample was obtained. Subsequently, the surface roughness of the film sample was measured with a laser microscope OLS5000 manufactured by Olympus Corporation. The measurement results were shown in Table 2.

### (Measurement of permittivity and dielectric tangent)

The permittivity at 10 GHz and the dielectric tangent of each of the films produced were measured with a measurement apparatus where a cavity resonator manufactured by AET, Inc. was connected to a spectrum network analyzer MS46122B model manufactured by Anritsu. The measurement results were shown in Table 2.

**[Table 2]**

| | Liquid crystal polymer particle | Amount of addition (%) | Ratio (a/b) | Thickness (µm) | Linear coefficient of expansion (10⁻⁶/°C) | Surface roughness Ra (µm) | Dielectric tangent tanδ | Permittivity |
|---|---|---|---|---|---|---|---|---|
| Example 4 | A1 | 30 | 1.8 | 25 | 32 | 0.23 | 0.0148 | 3.50 |
| Example 5 | A1 | 50 | 1.8 | 25 | 32 | 0.31 | 0.0102 | 3.35 |
| Example 6 | A2 | 30 | 2.1 | 25 | 24 | 0.27 | 0.0127 | 3.35 |
| Example 7 | A2 | 50 | 2.1 | 25 | 28 | 0.32 | 0.0107 | 3.53 |
| Example 8 | A3 | 30 | 2.3 | 25 | 31 | 0.34 | 0.0127 | 3.35 |
| Example 9 | A3 | 50 | 2.3 | 25 | 32 | 0.42 | 0.0089 | 3.33 |
| Comparative Example 2 | A4 | 50 | 1.1 | 25 | 37 | 1.63 | 0.0120 | 3.41 |
| Reference Example | - | - | - | 25 | 15 | 0.11 | 0.0192 | 3.70 |

In general, a firing condition in use of a liquid crystal polymer particle powder which is mixed with polyamic acid as a precursor of polyimide is appropriately adjusted to 300°C or more in order to impart a sufficiently high rate of imidation of polyimide. From the results, the flat liquid crystal polymer particle of the present invention can be used to thereby suppress an adverse influence on the dielectric tangent, the relative permittivity, and the surface roughness of a film, even if such adjustment is made.

### (Measurement of viscosity)

The viscosity of each of the liquid crystal polymer particles A1 to A3 produced which was added to a varnish was measured according to the following method. A suspension was obtained by adding 30 parts by mass of the liquid crystal polymer particle based on 100 parts by mass of polyamic acid in the polyamic acid varnish, to a solution obtained by diluting varnish U-varnish A (polyamic acid concentration 18%) manufactured by UBE Corporation, to two-thirds with N-methyl-2-pyrrolidone. The viscosity of the suspension obtained was measured with a B-type viscometer (IKA, apparatus name: ROTAVISC lo-vi Complete) equipped with an SP-4-type spindle, under conditions of a rotational speed of 100 rpm and a temperature of 25°C. The viscosity of a polyamic acid varnish to which no liquid crystal polymer particle was added was also measured similarly.

The measurement results were shown in Table 3. A varnish to which the flat liquid crystal polymer particle of the present invention is added does not cause any remarkable increase in viscosity to be observed, which makes flowing difficult, as compared with a varnish to which no liquid crystal polymer particle is added, and is suitable for film production in a production process.

**[Table 3]**

| Liquid crystal polymer particle | Viscosity of varnish (at 100 rpm/SP4) |
|---|---|
| A1 | 712 |
| A2 | 834 |
| A3 | 937 |
| Not added | 637 |

### Reference Signs List

1: resin film
2: flat liquid crystal polymer particle
3: longer size
4: shorter size
5: thickness
T: TD direction
M: MD direction
6: molded body
7: Feret's diameter in longitudinal direction (MD direction)
8: Feret's diameter in perpendicular direction (TD direction) to longitudinal direction

## Claims

1. A liquid crystal polymer particle in which 80% by mass or more of the entire particle is flat, wherein
a longer size, a shorter size, and a thickness defined below of a flat liquid crystal polymer particle satisfy the following conditions (A) and (B):
(A) an elongation as the ratio of the longer size and the shorter size is 1.2 or more and 5.0 or less, and
(B) a degree of flatness as the ratio of the shorter size and the thickness is 1.2 or more.

2. The liquid crystal polymer particle according to claim 1, having a melting point of 270°C or more, wherein
a size D₅₀ corresponding to 50% of a cumulative distribution in a particle size distribution is 20 µm or less and a size D₉₀ corresponding to 90% of the cumulative distribution is 2.5 times or less the D₅₀.

3. The liquid crystal polymer particle according to claim 1 or 2, wherein the liquid crystal polymer particle has a dielectric tangent of 0.001 or less.

4. The liquid crystal polymer particle according to any one of claims 1 to 3, wherein the liquid crystal polymer particle contains a structural unit (I) derived from hydroxycarboxylic acid, a structural unit (II) derived from a diol compound, and a structural unit (III) derived from dicarboxylic acid.

5. The liquid crystal polymer particle according to claim 4, wherein the structural unit (I) derived from hydroxycarboxylic acid is a structural unit derived from 6-hydroxy-2-naphthoic acid.

6. The liquid crystal polymer particle according to claim 4 or 5, wherein a compositional ratio of the structural unit (I) is 40% by mol or more and 80% by mol or less relative to the entire structural unit of the liquid crystal polymer particle.

7. A thermosetting resin composition comprising:
the liquid crystal polymer particle according to any one of claims 1 to 6; and
a thermosetting resin.

8. The thermosetting resin composition according to claim 7, wherein a ratio of a viscosity of the thermosetting resin composition to a viscosity of the thermosetting resin is 30 or less.

9. The thermosetting resin composition according to claim 7 or 8, wherein a content of the liquid crystal polymer particle is 5 parts by mass or more and 80 parts by mass or more based on 100 parts by mass of the thermosetting resin.

10. The thermosetting resin composition according to any one of claims 7 to 9, wherein the thermosetting resin is at least one selected from the group consisting of an epoxy resin, a phenol resin, a polyimide resin, and a bismaleimide-triazine resin.

11. A molded body formed from the thermosetting resin composition according to any one of claims 8 to 10, wherein
the molded body has a film shape, a sheet shape, or a plate shape, and
a ratio (a/b) of an average value a of a Feret's diameter in a longitudinal direction of the flat liquid crystal polymer particle and an average value b of a Feret's diameter in a perpendicular direction to the longitudinal direction is 1.2 or more.

12. The molded body according to claim 11, wherein the ratio (a/b) is 1.2 or more and 10.0 or less.

13. The molded body according to claim 11 or 12, wherein the molded body is a resin film having a thickness of 25 µm or less.

14. The molded body according to any one of claims 11 to 13, wherein the resin film has a surface roughness Ra of 1.0 µm or less.
